Europäisches Patentamt

European Patent Office

Office européen des brevets

(11) Publication number: **0 050 022**
**B1**

(12) **EUROPEAN PATENT SPECIFICATION**

(45) Date of publication of patent specification: **02.01.91**

(51) Int. Cl.⁵: **G 11 C 11/40**

(21) Application number: **81304710.7**

(22) Date of filing: **09.10.81**

(54) **Static type semiconductor memory device.**

(30) Priority: **09.10.80 JP 141655/80**

(43) Date of publication of application:
**21.04.82 Bulletin 82/16**

(45) Publication of the grant of the patent:
**02.01.91 Bulletin 91/01**

(84) Designated Contracting States:
**DE FR GB NL**

(56) References cited:
**DE-A-2 852 985**
**GB-A-1 157 323**
**US-A-4 096 584**

**IBM TECHNICAL DISCLOSURE BULLETIN, vol.
22, no. 3, August 1979, New York (US)**

**PATENT ABSTRACTS OF JAPAN, vol. 1, no. 124,
October 18, 1977, page 5351 E 77**

(73) Proprietor: **FUJITSU LIMITED**
**1015, Kamikodanaka Nakahara-ku
Kawasaki-shi Kanagawa 211 (JP)**

(72) Inventor: **Oritani, Atsushi
37-22 Nakakibogaoka Asahi-ku
Yokohama-shi Kanagawa 241 (JP)**

(74) Representative: **Rackham, Stephen Neil et al
GILL JENNINGS & EVERY 53-64 Chancery Lane
London WC2A 1HN (GB)**

Courier Press, Leamington Spa, England.

## Description

The present invention relates to a static type semiconductor memory device.

In recent years, the memory capacity of a semiconductor memory device has increased and with increasing memory capacity the load current on each of the bit lines becomes large and also the stray capacitance of each of the bit lines increases, so that the operating speed of the memory device decreases.

Patent Abstracts of Japan, Vol. 1, No. 24, October 18, 1977, p. 5351E77 (JP—A—5258327) discloses an array of memory cells divided into blocks. Each block includes divided word lines and divided bit lines.

According to this invention, a static-type semiconductor memory device comprising a memory cell array having memory cells arranged at the crossing points of a plurality of word lines and a plurality of bit lines, the memory cell array being divided into at least four memory cell blocks which are formed by divisions extending in a direction parallel to the word lines and to the bit lines with each memory cell block including divided word lines and divided bit lines, the memory device also comprising a word decoder means and a column decoder means, is characterised in that said decoder means are arranged between the memory cell blocks such that each decoder is operable on two adjacent blocks and in that gating means are provided to enable each word decoder and each column decoder to select only the divided word line and divided bit line respectively of the memory cell block containing the memory cell selected by a particular input address signal.

Two particular examples of a memory device in accordance with this invention will now be described and contrasted with the prior art with reference to the accompanying drawings; in which:—

Figures 1A and 1B are block diagrams of a conventional static-type semiconductor RAM;

Figure 2 is a block diagram of a first example of static-type semiconductor memory device in accordance with the present invention;

Figure 3 is a block diagram of a second example of static type semiconductor memory device in accordance with the present invention; and,

Figures 4A and 4B are circuit diagrams illustrating details of the structure of the second example.

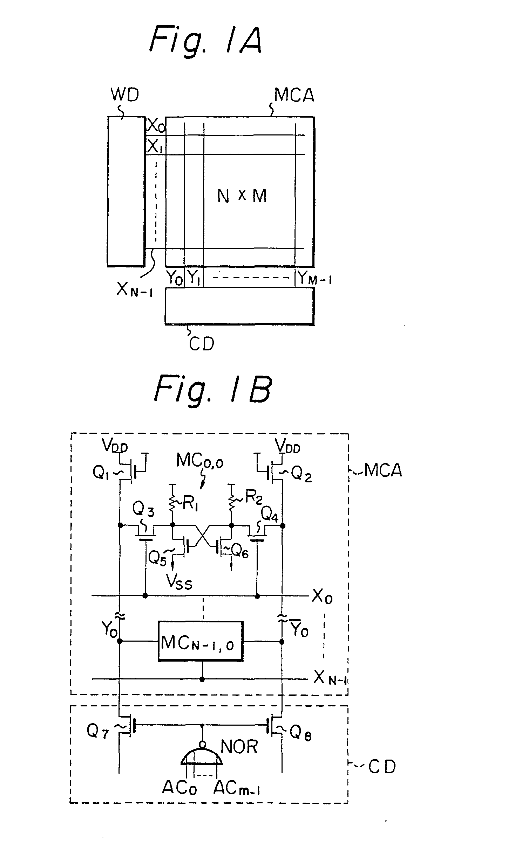

In Figure 1A and 1B MCA designates a memory cell array having static type memory cells $MC_{0,0}$; ...; $MC_{N-1,0}$; ... which are disposed in a matrix of N rows and M columns. For example, when a word line $X_0$ is selected by a word address decoder WD and a bit line or bit line pair $Y_0$ and $\overline{Y}_0$ is selected by a column decoder CD, a memory cell $MC_{0,0}$ disposed on a cross point of the word line $X_0$ and the bit line $Y_0$ is selected. Each of the memory cells, for example $MC_{0,0}$, comprises MIS transistors Q3 to Q6 and load resistors R1 and R2. Only one of the cross coupled transistors Q5 and Q6 is turned on by this means, and the other is turned off according to the information stored in the memory cell $MC_{0,0}$. When the word line $X_0$ is selected and the potential of the word line $X_0$ becomes, for example, high, the transfer transistors Q3 and Q4 are turned on. If the transistor Q5 is turned on, a current flows from a voltage source $V_{DD}$ through a MIS bit line load transistor Q1 of the bit line $Y_0$, the transistor Q3 and the transistor Q5 to another voltage source $V_{SS}$. In this condition, the transistor Q6 is turned off and no current flows through a MIS load transistor Q2 of the bit line $\overline{Y}_0$. Accordingly, there exists a potential difference between the bit lines $Y_0$ and $\overline{Y}_0$. A sense amplifier, which is not shown in the drawings detects the potential difference and outputs the information stored in the memory cell $MC_{0,0}$. In Figure 1B, MIS transistors Q7 and Q8 of the column decoder CD connect the selected bit line pair $Y_0$ and $\overline{Y}_0$ to the sense amplifier under the control of the output signal from a NOR gate "NOR" which receives column address signals $AC_0$, through $AC_{m-1}$, where $2^m=M$.

Concerning the power consumption of the above-mentioned static type RAM device, more than 60% of the total power consumption is consumed by memory cell array portion and the other is consumed by the peripheral circuit portion of the memory cell array portion. According to the increase in the memory capacity, the ratio of the electric power consumed by the memory cell array portion becomes larger and larger, but the electric power consumed by the peripheral circuit portion does not increase much. Of the electric power consumed by the memory cell portion, most of the power consumption is caused by the bit line current flowing at the access time, i.e. at the time the read out or the write in of information is effected and the electric current for holding the information stored in the memory cells is very small. Therefore, it is essential to decrease the power consumption of the memory cell array portion, especially to decrease the bit line current, in order to decrease the power consumption of the memory device.

In order to decrease the bit line current, it is possible to divide each of the word lines into two half sections and to select only one of the half sections to which the selected memory cell is connected. In such a structure, another one of the half sections of the selected word line is not selected and, therefore, the total current flowing from the bit lines through the memory cell to the ground can be reduced approximately by one half. However, in such a memory device, the length of each of the bit lines is the same as that of the memory device of Figure 1, and the stray capacitance of each of the bit lines becomes very large when the memory capacity is increased. Therefore, it is necessary to increase the charge current flowing from the transistors Q1 and Q2 to the bit lines, so that the power consumption becomes large when the memory capacity is increased.

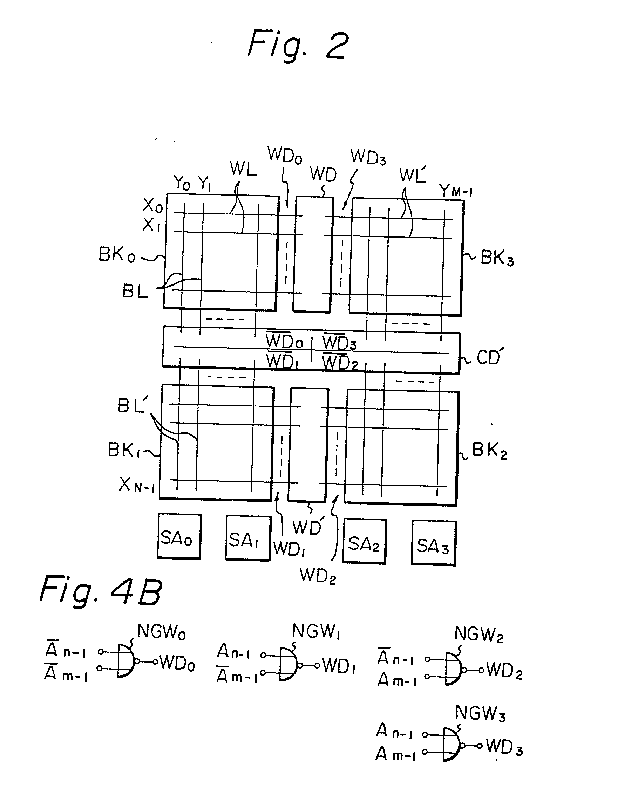

As illustrated schematically in Figure 2, in a semiconductor RAM device as a first embodiment of the present invention, a memory cell array is divided into four cell array blocks $BK_0$ to $BK_3$, and word lines $X_0$ to $X_{N-1}$ and bit lines $Y_0$ to $Y_{M-1}$ are respectively divided into two sections at the central portions thereof. In Figure 2, WL and WL' designate divided word line sections of each of the word lines $X_0$ to $X_{N-1}$, and BL and BL' designate divided bit line sections of each of the bit lines $Y_0$ to $Y_{M-1}$. WD and WD' are word decoders disposed between the cell array blocks $BK_0$ and $BK_3$ and the cell array blocks $BK_1$ and $BK_2$. The word decoder WD selects one of the divided word lines WL of the cell array block $BK_0$ when a selecting signal $WD_0$ for the cell array block $BK_0$ is applied to the word decoder WD, and selects another one of the divided word lines WL' of the cell array $BK_3$ when a selecting signal $WD_3$ for the cell array block $BK_3$ is applied to the word decoder WD. The word decoder WD' selects one of the divided word lines WL of the cell array block $BK_1$ when a selecting signal $WD_1$ is applied thereto and selects one of the divided word lines WL' of the cell array block $BK_2$ when a selecting signal $WD_2$ is applied thereto. One of the N/2 word lines of each of the cell array blocks is selected by a n−1 bit address signals which are applied to the word decoders WD and WD' and which are not shown in Figure 2, where $2^n = N$. The above-mentioned selecting signals $WD_0$ to $WD_3$ are formed from two bit address signals, each of which is also applied to the word decoder WD and WD' respectively. Therefore, the word lines $X_0$ to $X_{N-1}$ are selected by n bit address signals.

In Figure 2, CD' is a column decoder which selects one of the divided bit line BL or BL' of the bit lines $Y_0$ to $Y_{M-1}$. Input address signals to the column decoder CD' include the inverted signals $WD_0$ to $WD_3$ of the aforementioned selecting signals $WD_0$ to $WD_3$ so that the column decoder CD' can select one of the divided bit lines from one of the cell array blocks $BK_0$ to $BK_3$ which is selected by the word decoder WD or WD'. Since the column decoder CD' selects one of the divided bit lines by applying a selecting pulse of a negative polarity, the inverted signals $WD_0$ to $WD_3$ are applied to the column decoder CD'. If a column decoder which selects the divided bit line by applying a selecting pulse of a positive polarity, is used, non-inverted signals $WD_0$ to $WD_3$ are applied to the column decoder. In Figure 2, $SA_0$ to $SA_3$ designate sense amplifiers connected to the cell array blocks $BK_0$ to $BK_3$ respectively.

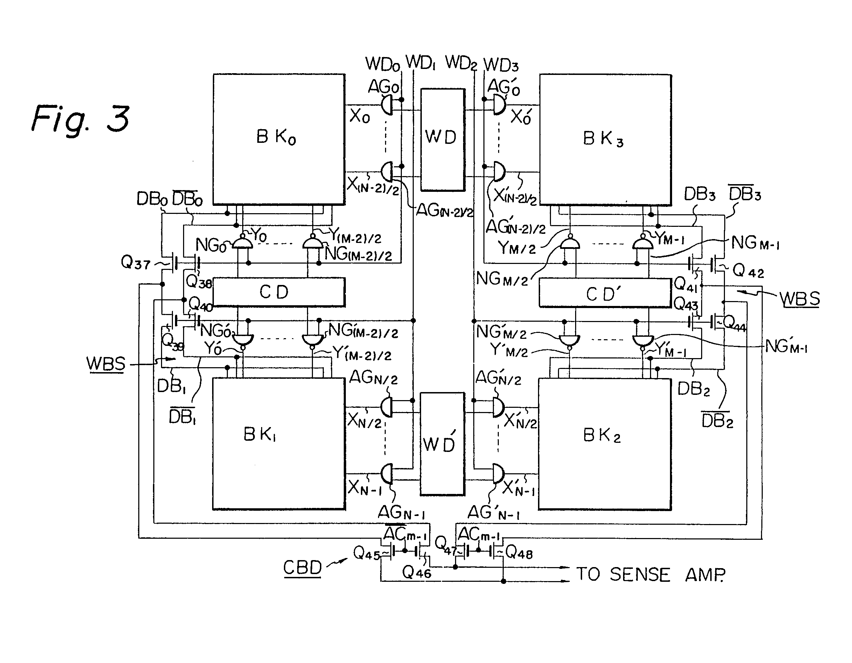

Figure 3 illustrates a static type RAM device as another embodiment of the present invention. The RAM device of Figure 3 comprises four cell array blocks $BK_0$ through $BK_3$, word decoders WD and WD', column decoders CD and CD', AND gates $AG_0$ to $AG_{N-1}$ and $AG'_0$ to $AG'_{N-1}$, NOR gates $NG_0$ to $NG_{M-1}$ and $NG'_0$ to $NG'_{M-1}$, gate transistors Q37 to Q44 constituting a word block selector WBS and gate transistors Q45 to Q48 constituting column block selector CBD.

The RAM device of Figure 3 has substantially the same structure as that of the memory device of Figure 2, except that the RAM device of Figure 3 uses only one sense amplifier which is connected to the gate transistors Q45, Q46 and Q47, Q48 and which is not shown in Figure 3. Each of the cell array blocks $BK_0$ to $BK_3$ has (N/2)×(M/2) bit memory cells arranged in a matrix of N/2 rows and M/2 columns, and selected by selecting signals $WD_0$ to $WD_3$, respectively. For example, when the selecting signals $WD_0$ becomes high, the word decoder WD selects one of divided word lines $X_0$ to $X_{(N-2)/2}$ of the cell array block $BK_0$ to the AND gates $AG_0$ to $AG_{(N-2)/2}$ and the column decoder CD selects one of divided bit lines $Y_0$ to $Y_{(M-2)/2}$ of the same cell array block $BK_0$ to the NOR gates $NG_0$ through $NG_{(M-2)/2}$. Therefore, when the selecting signal $WD_0$ is high, one of memory cells of the cell array block $BK_0$ is selected, and, for example, a read out signal from the selected memory cell is transferred through data buses $DB_0$ and $\overline{DB_0}$ and the gate transistors Q37 and Q38 which are turned on by the selecting signal $WD_0$ and through the gate transistors Q45 and Q46 to the sense amplifier (not shown in the drawing). The read out of information from each of the memory cells of the other cell array blocks $BK_1$ to $BK_3$ is effected in a similar manner to the read out of information from one of the memory cells of the cell array block $BK_0$ which is mentioned above. The gate transistors Q45, Q46, and Q47, Q48, constitute a column block selector CBD and select one of the groups of the cell array blocks each consisting of the cell array blocks $BK_0$ and $BK_1$ or $BK_3$ and $BK_2$. The gate transistors Q45 and Q46 are controlled, for example, by the most significant bit $\overline{AC_{m-1}}$ of the column address signal and the gate transistors Q47 and Q48 are controlled by the inverted signal $AC_{m-1}$ of the most significant bit of the column address signal.

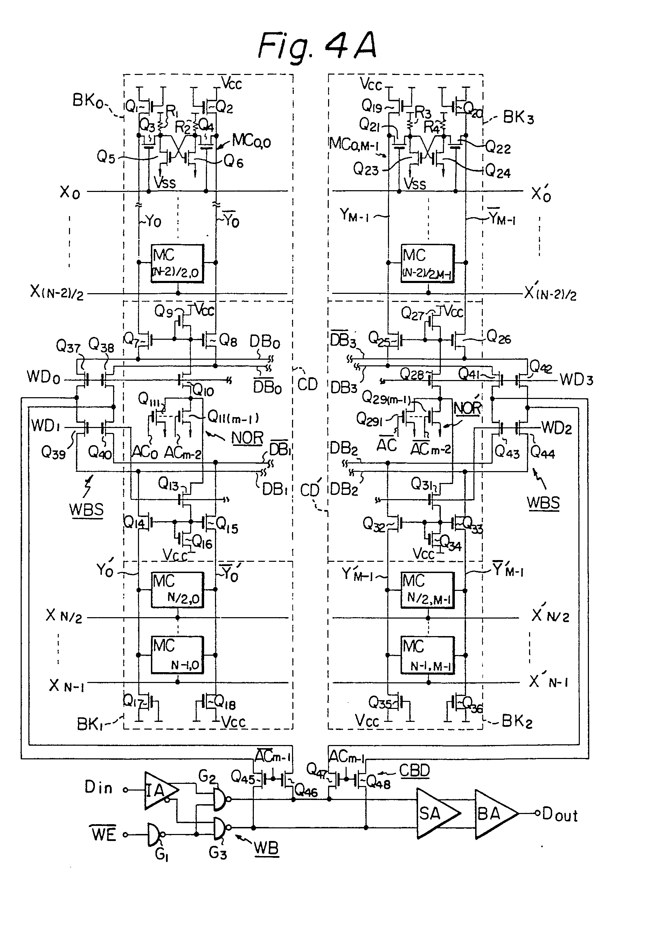

Figure 4A is a partial detailed circuit diagram of the RAM device of Figure 3. As illustrated in Figure 4A, each of the memory cells of the cell array blocks $BK_0$ to $BK_3$ is constituted mainly by a flip-flop circuit. For example, the memory cell $MC_{0,0}$ of the cell array block $BK_0$ comprises a pair of cross coupled MIS transistors Q5 and Q6, load resistors R1 and R2 connected between the drain electrode of the transistor Q5 and a voltage source $V_{cc}$ and between the drain electrode of the transistor Q6 and the voltage source $V_{cc}$ respectively, and, a pair of MIS transfer transistors Q3 and Q4 connected beween the drain electrode of the transistor Q6 and a divided bit line $Y_0$ and between the drain electrode of the transistor Q6 and a divided bit line $\overline{Y_0}$. The gate electrodes of the transistors Q3 and Q4 are connected to a divided word line $X_0$. In this manner, N/2 bits memory cells $MC_{0,0}$ to $MC_{(N-2)/2,0}$ of the cell array block $BK_0$ are connected between a pair of divided bit lines $Y_0$ and $\overline{Y_0}$ and to the divided word lines $X_0$ to $X_{(N-2)/2}$. The divided bit lines $Y_0$ and $\overline{Y_0}$ are connected to the voltage source $V_{cc}$ through bit line load transistors Q1 and Q2, respectively. The divided bit lines $Y_0$ and $\overline{Y_0}$ are connected to the data buses $DB_0$ and $\overline{DB_0}$ respectively, through MIS transistors Q7 and Q8. These transistors Q7 and Q8 are turned on and off by a bit drive signal supplied from a NOR gate of a column decoder CD constituted by MIS transistors Q11$_1$to Q11$_{(m-1)}$, through a MIS transistor Q10 which is controlled by the aforementioned selecting signal WD$_0$. The MIS transistors Q11$_1$ to Q11$_{(m-1)}$ are turned on and off by m−1 bit column address signals AC$_0$ to AC$_{m-2}$, respectively, which are supplied from column address buffers (not shown in the drawing). A depletion type MIS transistor Q9 is a load transistor for the MIS transistor Q10 and for the MIS transistors Q11$_1$ to Q11$_{(m-1)}$ constituting the NOR gate.

The divided bit lines Y'$_0$ and $\overline{Y}'_0$ of the cell array block BK$_1$ are connected to the data buses DB$_1$ and $\overline{DB}_1$ through MIS transistors Q14 and Q15. The MIS transistors Q14 and Q15 are also controlled by the NOR gate "NOR" through a MIS transistor Q13 which is controlled by the selecting signal WD$_1$. The bit lines Y'$_0$ and $\overline{Y}'_0$ are connected to the voltage source V$_{cc}$ through load transistors Q17 and Q18, respectively. N/2 bits memory cells MC$_{N/2,0}$ to MC$_{N-1,0}$ are connected between the divided bit lines Y'$_0$ and $\overline{Y}_1$ and to the divided word lines X$_{N/2}$ to X$_{N-1}$.

The structure of the other cell array blocks BK$_3$ and BK$_2$ and the other column decoder CD' are substantially the same as those of the cell array blocks BK$_0$ and BK$_1$ and the column decoder CD.

The data buses DB$_0$ and $\overline{DB}_0$, and, DB$_1$ and $\overline{DB}_1$ are commonly connected to the gate transistors Q45 and Q46 of the column block decoder CBD through the gate transistors Q37 and Q38 of the word block selector WBS and through the gate transistors Q39 and Q40 of the word block selector WBS, respectively. Similarly, the data buses DB$_3$ and $\overline{DB}_3$ and DB$_2$ and $\overline{DB}_2$ are commonly connected to the gate transistors Q48 and Q47 of the column block decoder CBD through the gate transistors Q41 and Q42 of the word block selector WBS and through the gate transistors Q43 and Q44 of the word block selector WBS, respectively. The column block selector CBD is connected to a sense amplifier SA and a buffer amplifier BA and to a write-in buffer WB constituted by an input amplifier and three NAND gates G1 to G3.

The selecting signals WD$_0$ to WD$_3$ are formed by NAND gates NGW$_0$ to NGW$_3$ respectively to which the address signals A$_{n-1}$, $\overline{A}_{n-1}$, A$_{m-1}$, $\overline{A}_{m-1}$ are applied, as illustrated in Figure 4B.

The operation of the circuit of Figures 4A and 4B will now be explained. When the read-out of information from the memory cell, for example, MC$_{00}$ is effected, the potential level of the divided word line X$_0$ is caused to be high and the transistors Q3 and Q4 are turned on. In this case, the column address signals AC$_0$ to AC$_{m-2}$ are all low and the selecting signal WD$_0$ is high. Therefore, the transistors Q10, Q37 and Q38 are all turned on and the level of the output potential of the NOR gate "NOR" is high, so that the transistors Q7 and Q8 are both turned on. In this case, since the column address signal $\overline{AC}_{m-1}$ is high, the transistors Q45 and Q46 are turned on. Therefore, the potential difference between the drain electrodes of the transistors Q5 and Q6 of the memory cell MC$_{0,0}$ is transferred to the sense amplifier SA and the buffer amplifier BA and the read-out data D$_{out}$ corresponding to the potential difference is output.

When the write-in of information to the same memory cell is effected, the potential level of the word line X$_0$ is caused to be high, the selecting signal WD$_0$ is caused to be high and the column address signals AC$_0$ to AC$_{m-1}$ are all caused to be low. Therefore, a write-in signal from the write-in buffer WB is transferred to the memory cell MC$_{0,0}$ and the write-in of information is effected.

In these operations, only divided word line X$_0$ becomes high and all the other divided word lines of the cell array block BK$_0$ and of the cell array blocks BK$_1$ to BK$_3$ are low. Therefore, the load current flowing from the bit lines through the memory cells to the voltage source V$_{ss}$ (for example, ground) can be decreased to half that of the conventional memory device of Figure 1. Moreover, since the gate transistors Q14 and Q15 are in a turned off condition, the stray capacitance of the bit line pair Y$_0$ and $\overline{Y}_0$ is decreased to half that of the conventional memory device of Figure 1. Therefore, the gm of each of the load transistors Q1 and Q2 can be decreased to half that of the conventional memory device, i.e. the charge current of each of the bit lines can be decreased to half that of the conventional memory device without reducing the charging speed of each of the bit lines. As a result, the power consumption of the above mentioned memory device can be decreased to a quarter of that of the conventional memory device of Figure 1.

In the above embodiments, the memory cell array is divided into four blocks. However, it should be noted that the memory cell array can be divided into a larger number of blocks, and it is possible to decrease the power consumption of the memory device even more.

Therefore, according to the present invention, it is possible to decrease the power consumption of the static type RAM device having a large memory capacity without reducing the operation speed thereof.

**Claims**

1. A static-type semiconductor memory device comprising a memory cell array having memory cells arranged at the crossing points of a plurality of word lines (X$_0$, X$_1$, ... X$_{N-1}$) and a plurality of bit lines (Y$_0$, Y$_1$, ... Y$_{M-1}$), the memory cell array being divided into at least four memory cell blocks (BK$_0$, BK$_1$, BK$_2$, BK$_3$) which are formed by divisions extending in a direction parallel to the word lines (X$_0$, X$_1$, ... X$_{N-1}$) and to the bit lines (Y$_0$, Y$_1$, ... Y$_{M-1}$) with each memory cell block (BK$_0$, BK$_1$, BK$_2$, BK$_3$) including divided word lines (X$_0$, X$_0'$, ... X$_{N-1}$, X$_{N'-1}$) and divided bit lines (Y$_0$, Y$_{0'}$, ... Y$_{M-1}$, Y$_{M'-1}$), the memory device also comprising a word decoder means (WD, WD') and a column decoder means (CD, CD') characterised in that said decoder means (WD, WD', CD, CD') are arranged between the memory cell blocks (BK$_0$, BK$_1$, BK$_2$,

BK₃) such that each decoder is operable on two adjacent blocks and in that gating means are provided to enable each word decoder and each column decoder to select only the divided word line ($X_0$, $X_{0'}$, ... $X_{N-1}$, $X_{N'-1}$) and divided bit line ($Y_0$, $Y_{0'}$, ... $Y_{M-1}$, $Y_{M'-1}$), respectively, of the memory cell block containing the memory cell (MC) selected by a particular input address signal.

2. A memory device according to claim 1, which also includes block selection signal generating portion (Figure 4B) which generates a number of block selection signals $WD_0\sim WD_3$ corresponding to the number of the blocks, the word decoder means (WD, WD'), and the column decoder means (CD, CD') selecting only the divided word line and divided bit line of the blocks including the selected cell, in accordance with the block selection signals and do not select the divided word line and divided bit line of the blocks not including a selected cell.

3. A memory device according to claim 1 or 2, wherein the word decoder means (WD, WD') comprises a plurality of word decoders ($WD_0$, $WD_1$, ...) each of which selects one of the divided word lines ($X_0$, $X_0'$, ... $X_{N-1}$, $X_{N'-1}$) of one of the memory cell blocks ($BK_0$, $BK_1$, $BK_2$, $BK_3$).

4. A memory device according to claim 3, wherein the word decoder means (WD, WD') further comprises a word block selector (WBS) which selects the one of the memory cell blocks using selection signals made from part of the input address signals.

5. A memory device according to any one of the preceding claims, wherein the column decoder means (CD, CD') comprises a plurality of column decoders ($CD_0$, $CD_1$, ...), each of which selects one of the divided bit lines ($Y_0$, $Y_0'$, ... $Y_{M-1}$, $Y_{M'-1}$) of the memory cell blocks ($BK_0$, $BK_1$, $BK_2$, $BK_3$).

6. A memory device according to claim 5, wherein the column decoder means (CD, CD') further comprises a column block selector (CBS) which selects a group of the memory cell blocks disposed in the same column using part of the input address signals.

7. A memory device according to any one of the preceding claims, wherein the word decoder means (WD, WD') are arranged between the memory cell blocks ($BK_0$, $BK_1$, $BK_2$, $BK_3$).

8. A memory device according to any one of the preceding claims wherein the column decoder means (CD, CD') are arranged between the memory cell blocks ($BK_0$, $BK_1$, $BK_2$, $BK_3$).

9. A memory device according to any one of the preceding claims, wherein each of the memory cells comprises a pair of cross coupled MIS transistors, a pair of load elements connected between a voltage source and the pair of cross coupled MIS transistors, and a pair of transfer MIS transistors which are connected between the pair of cross coupled MIS transistors and a pair of divided bit lines, the gate electrodes of the pair of transfer MIS transistors being connected to the divided word line.

10. A memory device according to claim 9, wherein the divided bit lines are connected to a voltage source through bit line loads.

11. A memory device according to any one of the preceding claims, wherein the memory device includes a sense amplifier (SA) which senses information from the selected memory cell (MC) and wherein only the divided bit line which is selected is connected to the sense amplifier (SA).

**Patentansprüche**

1. Statische Halbleiterspeichervorrichtung mit einem Speicherzellenfeld, das Speicherzellen hat, die an Kreuzungspunkten einer Vielzahl von Wortleitungen ($X_0$, $X_1$, ... $X_{N-1}$) und einer Vielzahl von Bitleitungen ($Y_0$, $Y_1$, ... $Y_{M-1}$) angeordnet sind, welches Speicherzellenfeld in wenigstens vier Speicherzellenblöcke ($BK_0$, $BK_1$, $BK_2$, $BK_3$) unterteilt ist, die durch Teilungen gebildet sind, die sich in einer Richtung parallel zu den Wortleitungen ($X_0$, $X_1$, ... $X_{N-1}$) und zu den Bitleitungen ($Y_0$, $Y_1$, ... $Y_{M-1}$) erstrecken, wobei jeder Speicherzellenblock ($BK_0$, $BK_1$, $BK_2$, $BK_3$) geteilte Wortleitungen ($X_0$, $X_0'$, ... $X_{N-1}$, $X_{N'-1}$) und geteilte Bitleitungen ($Y_0$, $Y_{0'}$, ... $Y_{M-1}$, $Y_{M'-1}$) enthält, die Speichervorrichtung auch Wortdecodereinrichtungen (WD, WD') und eine Spaltendecodereinrichtungen (CD, CD') enthält, dadurch gekennzeichnet, daß die Decodereinrichtungen (WD, WD', CD, CD') zwischen den Speicherzellenblöcken ($BK_0$, $BK_1$, $BK_2$, $BK_3$) so angeordnet sind, daß jeder Decoder auf zwei benachbarte Blöcke wirkt, und daß Toreinrichtungen vorgesehen sind, um jedem Wortdecoder und jedem Spaltendecoder zu ermöglichen, nur die ausgewählte Wortleitung ($X_0$, $X_0'$, ... $X_{N-1}$, $X_{N'-1}$) und die geteilte Bitleitung ($Y_0$, $Y_{0'}$, ... $Y_{M-1}$, $Y_{M'-1}$) jeweils des Speicherzellenblockes auszuwählen, der die Speicherzelle (MC) enthält, die durch ein besonderes Eingangsadreßsignal ausgewählt ist.

2. Speichervorrichtung nach Anspruch 1, die ferner einen Blockauswahl-Signalgeneratorabschnitt (Figur 4B) enthält, der eine Zahl von Blockauswahlsignalen ($WD_0\sim WD_3$) erzeugt, die der Zahl der Blöcke entsprechen, wobei die Wortdecodereinrichtungen (WD, WD') und die Spaltendecodereinrichtungen (CD, CD') nur die geteilte Wortleitung und die geteilte Bitleitung von den Blöcken auswählen, die die ausgewählte Zelle enthalten, in Übereinstimmung mit dem Blockauswahlsignalen, und nicht die geteilte Wortleitung und die geteilte Bitleitung von Blöcken auswählen, die keine ausgewählte Zelle enthalten.

3. Speichervorrichtung nach Anspruch 1 oder 2, bei der die Wortdecodereinrichtungen (WD, WD'), eine Vielzahl von Wortdecodern ($WD_0$, $WD_1$, ...) umfaßt, von denen jede eine der geteilten Wortleitungen ($X_0$, $X_{0'}$, ... $X_{N-1}$, $X_{N'-1}$) von einem der Speicherzellenblöcke ($BK_0$, $BK_1$, $BK_2$, $BK_3$) umfaßt.

4. Speichervorrichtung nach Anspruch 3, bei der die Wortdecodereinrichtungen (WD, WD') ferner einen Wortblockselektor (WBS) umfaßt, der den einen der Speicherzellenblöcke, unter Verwendung von Auswahlsignalen, die aus einem Teil der Eingangsadreßsignale gebildet sind, auswählt.

5. Speichervorrichtung nach einem der vorhergehenden Ansprüche, bei der die Spaltendecodereinrichtungen (CD, CD') eine Vielzahl von Spantendecodern ($CD_0$, $CD_1$, ...) umfassen, von denen jeder eine der geteilten Bitleitungen ($Y_0$, $Y_{0'}$, ... $Y_{M-1}$, $Y_{M'-1}$) der Speicherzellenblöcke ($BK_0$, $BK_1$, $BK_2$, $BK_3$) auswählt.

6. Speichervorrichtung nach Anspruch 5, bei der die Spaltendecodereinrichtungen (CD, CD') ferner einen Spaltenblockselektor (CBS) umfaßt, der eine Gruppe von Speicherzellenblöcken, die in derselben Spalte angeordnet sind, unter Verwendung eines Teils der Eingangsadreßsignale, auswählt.

7. Speichervorrichtung nach einem der vorhergehenden Ansprüche, bei der die Wortdecodereinrichtungen (WD, WD') zwischen den Speicherzellenblöcken ($BK_0$, $BK_1$, $BK_2$, $BK_3$) angeordnet sind.

8. Speichervorrichtung nach einem der vorhergehenden Ansprüche, bei der die Spaltendecodereinrichtungen (CD, CD') zwischen den Speicherzellenblöcken ($BK_0$, $BK_1$, $BK_2$, $BK_3$) angeordnet sind.

9. Speichervorrichtung nach einem der vorhergehenden Ansprüche, bei der jede der Speicherzellen ein Paar von kreuzweise gekoppelten MIS-Transistoren, ein Paar von Lastelementen, die zwischen einer Spannungsquelle und dem Paar von kreuzweise gekoppelten MIS-Transistoren verbunden sind, und ein Paar von Transfer-MIS-Transistoren, die zwischen dem Paar von kreuzweise gekoppelten Transistoren und einem Paar von geteilten Bitleitungen verbunden sind, umfaßt, wobei die Gateelektroden des Paars von Transfer-MIS-Transistoren mit der geteilten Wortleitung verbunden sind.

10. Speichervorrichtung nach Anspruch 9, bei der die geteilten Bitleitungen über Bitleitungslasten mit einer Spannungsquelle verbunden sind.

11. Speichervorrichtung nach einem der vorhergehenden Ansprüche, bei der die Speichervorrichtung einen Leseverstärker (SA) umfaßt, der Information von der ausgewählten Speicherzelle (MC) liest, und bei der nur die geteilte Bitleitung ausgewählt wird, die mit dem Leseverstärker (SA) verbunden ist.

### Revendications

1. Dispositif de mémoire à semiconducteur du type statique comprenant une matrice de cellules de mémoire comportant des cellules de mémoire disposées aux points d'intersection d'un ensemble de fils de mot ($X_0$, $X_1$, ..., $X_{N-1}$) et d'un ensemble de fils de bit ($Y_0$, $Y_1$, ..., $Y_{M-1}$), la matrice de cellules de mémoire étant divisée en au moins quatre blocs de cellules de mémoire ($BK_0$, $BK_1$, $BK_2$, $BK_3$) qui sont formés par des divisions s'étendant dans une direction parallèle aux fils de mot ($X_0$, $X_1$, ..., $X_{N-1}$) et aux fils de bit ($Y_0$, $Y_1$, ..., $Y_{M-1}$), chaque bloc de cellules de mémoire ($BK_0$, $BK_1$, $BK_2$, $BK_3$) incluant des fils de mot divisés ($X_0$, $X_{0'}$, ..., $X_{N-1}$, $X_{N'-1}$) et des fils de bit divisés ($Y_0$, $Y_{0'}$, ..., $Y_{M-1}$, $Y_{M'-1}$), le dispositif de mémoire comprenant également un moyen décodeur de mot (WD, WD') et un moyen décodeur de colonne (CD, CD'), caractérisé en ce que les moyens décodeurs (WD, WD', CD, CD') sont disposés entre les blocs de cellules de mémoire ($BK_0$, $BK_1$, $BK_2$, $BK_3$) de telle sorte que chaque décodeur peut être mis en fonctionnement sur deux blocs voisins et en ce que des moyens de déclenchement sont prévus pour valider chaque décodeur de mot et chaque décodeur de colonne afin de ne sélectionner que le fil de mot divisé ($X_0$, $X_{0'}$, ..., $X_{N-1}$, $X_{N'-1}$) et le fil de bit divisé ($Y_0$, $Y_{0'}$, ..., $Y_{M-1}$, $Y_{M'-1}$), respectivement, du bloc de cellules de mémoire contenant la cellule de mémoire (MC) sélectionnée par un signal d'adresse d'entrée particulier.

2. Dispositif de mémoire selon la revendication 1, qui comprend également une partie génératrice de signaux de sélection de bloc (Figure 4B) qui génère un nombre de signaux de sélection de bloc ($WD_0$~$WD_3$) correspondant au nombre des blocs, le moyen décodeur de mot (WD, WD'), et le moyen décodeur de colonne (CD, CD') ne sélectionnant que le fil de mot divisé et le fil de bit divisé des blocs incluant la cellule sélectionnée, conformément aux signaux de sélection de bloc et ne sélectionnant pas le fil de mot divisé et le fil de bit divisé des blocs n'incluant pas une cellule sélectionnée.

3. Dispositif de mémoire selon l'une quelconque des revendications 1 et 2, dans lequel le moyen décodeur de mot (WD, WD') comprend un ensemble de décodeurs de mot ($WD_0$, $WD_1$, ...) dont chacun sélectionne un des fils de mot divisés ($X_0$, $X_0'$, ..., $X_{N-1}$, $X_{N'-1}$) d'un des blocs de cellulles de mémoire ($BK_0$, $BK_1$, $BK_2$, $BK_3$).

4. Dispositif de mémoire selon la revendication 3, dans lequel le moyen décodeur de mot (WD, WD') comprend en outre un sélecteur de bloc de mot (WBS) qui sélectionne le bloc parmi les blocs de cellules de mémoire mettant en oeuvre des signaux de sélection faisant partie des signaux d'adresse d'entrée.

5. Dispositif de mémoire selon l'une quelconque des revendications 1 à 4, dans lequel le moyen décodeur de colonne (CD, CD') comprend un ensemble de décodeurs de colonne ($CD_0$, $CD_1$, ...) dont chacun sélectionne un des fils de bit divisés ($Y_0$, $Y_{0'}$, ..., $Y_{M-1}$, $Y_{M'-1}$) des blocs de cellules de mémoire ($BK_0$, $BK_1$, $BK_2$, $BK_3$).

6. Dispositif de mémoire selon la revendication 5, dans lequel le moyen décodeur de colonne (CD, CD') comprend en outre un sélecteur de bloc de colonne (CBS) qui sélectionne un groupe des blocs de cellules de mémoire disposés dans la même colonne en mettant en oeuvre une partie des signaux d'adresse d'entrée.

7. Dispositif de mémoire selon l'une quelconque des revendications 1 à 6, dans lequel les moyens décodeurs de mot (WD, WD') sont disposés entre les blocs de cellules de mémoire (BK₀, BK₁, BK₂, BK₃).

8. Dispositif de mémoire selon l'une quelconque des revendications 1 à 7, dans lequel les moyens décodeurs de colonne (CD, CD') sont disposés entre les blocs de cellules de mémoire (BK₀, BK₁, BK₂, BK₃).

9. Dispositif de mémoire selon l'une quelconque des revendications 1 à 8, dans lequel chacune des cellules de mémoire comprend une paire de transistors MIS à couplage croisé, une paire d'éléments de charge connectés entre une source de tension et la paire de transistors MIS à couplage croisé, et une paire de transistors MIS de transfert qui sont connectés entre la paire de transistors MIS à couplage croisé et une paire de fils de bit divisés, les électrodes de grille de la paire de transistors MIS de transfert étant connectées au fil de mot divisé.

10. Dispositif de mémoire selon la revendication 9, dans lequel les fils de bit divisés sont connectés à une source de tension par l'intermédiaire de charges de fil de bit.

11. Dispositif de mémoire selon l'une quelconque des revendications 1 à 10, dans lequel le dispositif de mémoire comprend un amplificateur de détection (SA) qui détecte une information provenant de la cellule de mémoire sélectionnée (MC) et dans lequel le seul fil de bit divisé qui est sélectionné est connecté à l'amplificateur de détection (SA).

## Fig. 1A

## Fig. 1B

# Fig. 2

# Fig. 4B

Fig. 3

Fig. 4A